# EUROPÄISCHE PATENTSCHRIFT

(11) **EP 1 587 352 B1**
(45) Veröffentlichungstag und Bekanntmachung des Hinweises auf die Patenterteilung: **06.06.2012**
(21) Anmeldenummer: 05102272.1
(22) Anmeldetag: 22.03.2005
(51) Int. Cl.: H05K 5/06, H05K 7/14

(54) **Baugruppe mit mindestens zwei Teilkomponenten sowie Dichtungsmodul**
Assembly made of at last two parts, as also sealed module
Ensemble fait d' au moins deux parties, ainsi qu'un module étanche

(30) Priorität: 14.04.2004 DE 102004018115
(43) Veröffentlichungstag der Anmeldung: 19.10.2005
(73) Patentinhaber: SIEMENS AKTIENGESELLSCHAFT, 80333 München (DE)
(72) Erfinder: Bergmann, Martin, 92253, Schnaittenbach (DE)

(56) Entgegenhaltungen:
- DE-U1- 9 321 190
- FR-A- 2 655 809
- US-A- 4 943 686
- US-A- 5 239 446
- US-A1- 2002 079 653

## Beschreibung

Die Erfindung betrifft eine Baugruppe mit mindestens zwei Teilkomponenten, welche zur Baugruppe zusammensetzbar sind, sowie ein Dichtungsmodul.

Die US 5 239 446 A beschreibt ein wasserdichtes Gehäuse für ein elektronisches Gerät. Das Gehäuse besteht aus zwei Gehäuseteilen und einer Gehäuseabdeckung. Zwischen das erste Gehäuseteil und das zweite Gehäuseteil sowie zwischen das zweite Gehäuseteil und die Gehäuseabdeckung sind jeweils Dichtungen eingebracht. Das erste und das zweite Gehäuseteil und die Gehäuseabdeckung werden fest miteinander verbunden. Das erste Gehäuseteil weist eine Ausnehmung auf zur Aufnahme einer Leiterplatte.

DE 93 21 190 U1 offenbart eine Baugruppe mit mindestens zwei Teilkomponenten, welche zur Baugruppe zusammensetzbar sind, wobei mindestens ein Dichtungsmodul zur Aufnahme mindestens einer Dichtung vorgesehen ist, welches zwischen jeweils zwei Teilkomponenten einsetzbar ist.

Die US 4 943 686 A zeigt ein Dichtungsmodul das zwischen zwei Teilkomponenten einsetzbar ist.

Die FR 2 655 809 A zeigt ein Dichtungsmodul, auf das jeweils ein Deckel aufgeschraubt werden kann.

Die US 2002/079653 A1 zeigt eine Packungsanordnung mit mehreren Teilkomponenten, wobei zwischen einer Teilkomponente ein Substrat als ein Dichtmittel angeordnet ist.

Die US 5 239 446 A zeigt ein wasserdichtes Gehäuse für elektronische Vorrichtungen. Dabei wird offenbart, wie anhand eines Montageverfahrens mit Dichtungen dieses Gehäuse besonders wasserdicht gemacht werden kann.

Der Erfindung liegt die Aufgabe zugrunde, die Austauschbarkeit von Dichtungen bei aus mindestens zwei Teilkomponenten zusammengesetzten Baugruppen zu verbessern, insbesondere beim Vorliegen komplexer Dichtgeometrien.

Diese Aufgabe wird durch eine Baugruppe mit den im Anspruch 1 angegebenen Merkmalen gelöst. Die Baugruppe weist mindestens zwei Teilkomponenten auf, welche zur Baugruppe zusammensetzbar sind, wobei ein Dichtungsmodul zur Aufnahme mindestens von Dichtungen vorgesehen ist, welches zwischen jeweils zwei Teilkomponenten einsetzbar ist, dabei ist das Dichtungsmodul zwischen den zwei Teilkomponenten einer Baugruppe einsetzbar.

Insbesondere Baugruppen mit in höherer Schutzart ausgeführten Gehäusen werden üblicherweise verschiedenen Umgebungsbedingungen ausgesetzt. Solche Umgebungsbedingungen sind z.B. geprägt durch Flüssigkeiten, wie Öle, Säuren, Laugen oder auch durch klimatische Verhältnisse, wie besonders hohe oder niedrige Temperaturen. Um unterschiedlichsten Umgebungsbedingungen gerecht zu werden, werden üblicherweise zur Abdichtung der Gehäuse an die jeweilige Umgebungsbedingung angepasste O-Ringe hergestellt, welche aus verschiedenen Materialien bestehen. O-Ringe weisen den Vorteil auf, dass sie leicht tauschbar sind. Andererseits können bei komplexen Dichtgeometrien keine O-Ringe eingesetzt werden, da sich die O-Ringe in diesem Fall nur sehr schwer oder gar nicht montieren lassen. Beim Einsatz nicht tauschbarer Dichtungen ist bisher bei wechselnden Umgebungsbedingungen die Fertigung verschiedener Gehäuse mit jeweils an die Umgebungsbedingung angepassten Dichtungen erforderlich, wobei bei Bedarf das komplette Gehäuse getauscht werden muss. Der Erfindung liegt die Idee zugrunde, dass ein separates Dichtungsmodul zur Aufnahme mindestens einer Dichtung vorgesehen wird, wobei das Dichtungsmodul jeweils zwischen zwei Teilkomponenten einer aus Teilkomponenten zusammengesetzten Baugruppe einsetzbar ist. Auf diese Art können auch komplexe Dichtgeometrien realisiert werden. Für den Fall, dass die Baugruppe z.B. wegen Ausfalls getauscht werden muss, kann jeweils ein neues Dichtungsmodul mit einem neuen Dichtungssatz mitgeliefert werden.

Wenn gemäß einer vorteilhaften Ausgestaltung der Erfindung das Dichtungsmodul tauschbar ist, kann einerseits bei sich ändernden Umgebungsbedingungen die Baugruppe an diese Umgebungsbedingungen angepasst werden, andererseits kann eine Baugruppe mit verschiedenen für den jeweiligen Einsatzfall angepassten Dichtungsmodulen bereitgestellt werden. Vorteilhafterweise sind abhängig vom Einsatzfall Dichtungsmodule mit unterschiedlichen Dichtungen einsetzbar.

Die Handhabbarkeit der Erfindung lässt sich dadurch verbessern, dass die Dichtungen unverlierbar in das Dichtungsmodul eingebracht sind. Dies bietet insbesondere Vorteile gegenüber bisher verwendeten tauschbaren Dichtungen, wie z.B. O-Ringen.

Gemäß einer weiteren vorteilhaften Ausgestaltung der Erfindung weist das Dichtungsmodul elektrische Kontaktmittel zur Kopplung mit elektrischen Kontaktmitteln der Teilkomponenten auf.

Wenn das Dichtungsmodul gemäß einer weiteren vorteilhaften Ausgestaltung der Erfindung elektronische Bauteile aufweist, wird bei einem gegebenenfalls erforderlichen Austausch dieser elektronischen Bauteile durch Tausch des Dichtungsmoduls automatisch auch die Dichtung getauscht.

Nachfolgend wird die Erfindung anhand der in den Figuren dargestellten Ausführungsbeispiele näher beschrieben und erläutert. Es zeigen:
- FIG 1: eine Baugruppe mit zwei Teilkomponenten, jeweils im zusammengesetzten sowie im nicht zusammengesetzten Zustand,
- FIG 2: eine Baugruppe mit zwei Teilkomponenten, wobei das Dichtungsmodul elektrische Kontaktmittel aufweist.

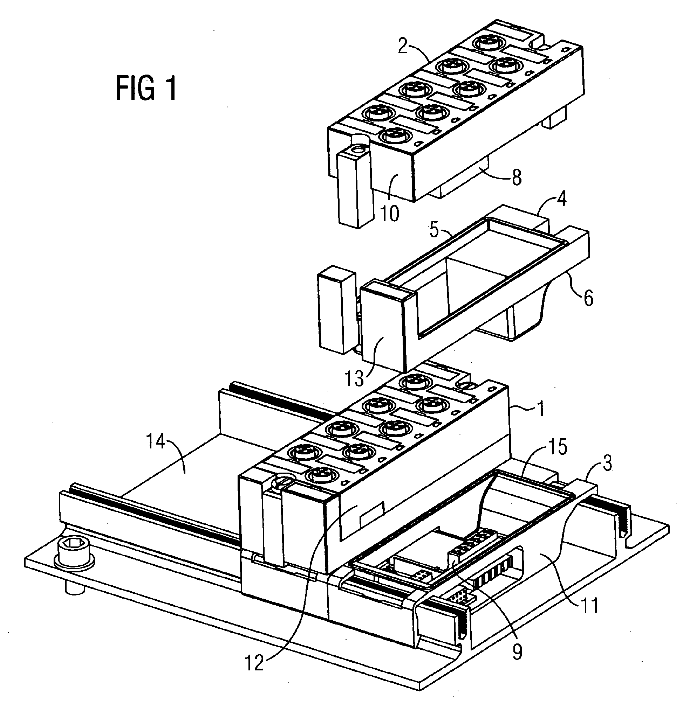

Figur 1 zeigt eine elektrische Baugruppe 1 mit zwei Teilkomponenten 2, 3, welche zur Baugruppe 1 zusammensetzbar sind. Eine solche Baugruppe 1 ist z. B. ein Peripheriemodul einer speicherprogrammierbaren Steuerung eines industriellen Automatisierungssystems. Die Baugruppe 1 gemäß Ausführungsbeispiel ist zur Montage auf einem Montageträger 14 vorgesehen. Die Baugruppe 1 ist sowohl im zusammengesetzten Zustand als auch im nicht zusammengesetzten Zustand dargestellt. Das Gehäuse 12 der zusammengesetzten Baugruppe 1 wird aus Gehäuseteilen 10, 11, 13 der Teilkomponenten 2, 3 bzw. des Dichtungsmoduls 4 gebildet. Im Ausführungsbeispiel ist die erste Teilkomponente 2 ein Basismodul, welches eine Leiterplatte mit elektronischen Komponenten aufnehmen kann. Die zweite Teilkomponente 2 ist als Steckermodul ausgebildet, welches zum Anschluss von externen Leitungen dient. Zur elektrischen Verbindung zwischen Steckermodul 2 und Basismodul 3 sind elektrische Kontaktmittel 8 bzw. 9 vorgesehen, welche im zusammengesetzten Zustand der Baugruppe miteinander kontaktiert sind. Die Dichtungen zur Abdichtung des Gehäuses 12 der Baugruppe 1 sind nicht an den Teilkomponenten 2, 3 angebracht, sondern im separaten Dichtungsmodul 4. Das Dichtungsmodul 4 weist an seiner Ober- bzw. Unterseite entsprechende Aufnahmen zur Aufnahme der Dichtungen 5, 6 auf. Die Dichtungen 5, 6 sind unverlierbar in das Dichtungsmodul 4 eingebracht. Bei Bedarf, z.B. bei wechselnden Umgebungsbedingungen, in denen die Baugruppe 1 eingesetzt werden soll, können an die jeweilige Umgebungsbedingung angepasste mit entsprechenden Dichtungen 5, 6 ausgestattete Dichtungsmodule 4 eingesetzt werden. Zum Tausch der Dichtungen 5, 6 muss nicht eine der Teilkomponenten 2, 3 getauscht werden, sondern lediglich das Dichtungsmodul 4. Die Teilkomponenten 2, 3 weisen Mittel 15, z.B. Nuten, auf, welche entsprechend der jeweiligen Geometrie der Dichtungen 5, 6 geformt sind, so dass im zusammengesetzten Zustand der Baugruppe 1 der jeweilige Übergang von Teilkomponente 2 zum Dichtungsmodul 4 bzw. vom Dichtungsmodul 4 zur Teilkomponente 3 abgedichtet wird. Das Dichtungsmodul 4 kann kostengünstig z. B. aus Kunststoff oder Metall gefertigt werden. Ein weiterer besonderer Vorteil der Erfindung liegt darin, dass die Teilkomponenten 2, 3 der Baugruppe unabhängig von den Umgebungsbedingungen, in denen die Baugruppe 1 eingesetzt werden soll, gefertigt werden können, da die zwischen den Teilkomponenten 2, 3 erforderliche, je nach Umgebungsbedingungen unterschiedlich auszuführende Abdichtung durch das tauschbare, mit unterschiedlichen Dichtungen 5, 6 fertigbare Dichtungsmodul 4 erfolgt.

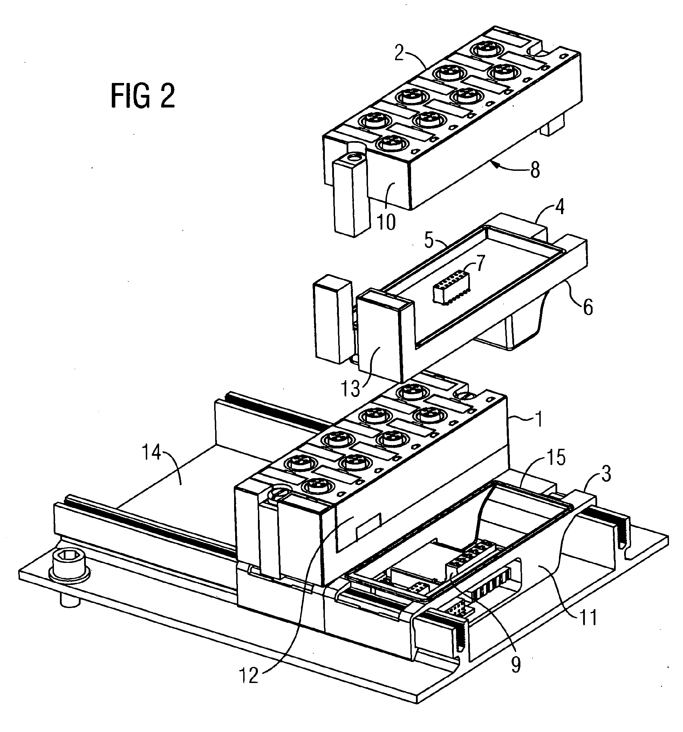

Figur 2 zeigt ein weiteres Ausführungsbeispiel der Erfindung, wobei das Dichtungsmodul 4 elektrische Kontaktmittel 7 zur Kopplung mit den elektrischen Kontaktmitteln 8, 9 der Teilkomponenten 2, 3 aufweist. Die Kontaktmittel 8 der Teilkomponente 2 sind in Figur 2 nicht direkt sichtbar. Mit gleichen Bezugszeichen wie in Figur 1 bezeichnete Teile erfüllen jeweils die gleiche Funktion, wie bei der Figurenbeschreibung zu Figur 1 beschrieben.

Nicht dargestellt ist ein weiteres Ausführungsbeispiel der Erfindung, bei welchem das Dichtungsmodul 4 elektronische Bauteile aufweist. So kann das Dichtungsmodul 4 eine Leiterplatte mit den gesamten für die Baugruppe erforderlichen E-lektronikkomponenten enthalten. Bei jedem Tausch der Elektronikkomponenten, z. B. durch einen Fehlerfall, durch Erweiterung oder durch Aktualisierung der Elektronik bedingt, wird dann zusammen mit dem Dichtungsmodul automatisch auch die Dichtung getauscht.

Zusammengefasst betrifft die Erfindung somit eine Baugruppe mit mindestens zwei Teilkomponenten 2, 3 sowie ein Dichtungsmodul. Um die Austauschbarkeit von Dichtungen 5, 6 bei aus mindestens zwei Teilkomponenten 2, 3 zusammengesetzten Baugruppen zu verbessern, insbesondere beim Vorliegen komplexer Dichtgeometrien, wird vorgeschlagen, dass die Baugruppe mit mindestens zwei Teilkomponenten 2, 3, welche zur Baugruppe zusammensetzbar sind, mindestens ein Dichtungsmodul zur Aufnahme mindestens einer Dichtung 5, 6 aufweist, welches zwischen jeweils zwei Teilkomponenten 2, 3 einsetzbar ist.

## Patentansprüche

1. Baugruppe (1) ausgestaltet als ein Peripheriemodul einer speicherprogrammierbaren Steuerung eines industriellen Automatisierungssystems mit mindestens zwei Teilkomponenten (2, 3), welche zur Baugruppe (1) zusammensetzbar sind, aufweisend ein Dichtungsmodul (4) zur Aufnahme von Dichtungen (5, 6), welches zwischen den zwei Teilkomponenten (2, 3) angeordnet ist, wobei das Dichtungsmodul (4) an einer Ober- und an einer Unterseite entsprechende Aufnahmen zur Aufnahme der Dichtungen (5, 6) aufweist, wobei eine Teilkomponente (2) als ein Steckermodul zum Anschluss von externen Leitungen ausgebildet ist, und dass das Dichtungsmodul (4) elektrische Kontaktmittel (7) zur Kopplung mit elektrischen Kontaktmitteln (8, 9) der Teilkomponenten (2, 3) aufweist.

2. Baugruppe nach Anspruch 1,
**dadurch gekennzeichnet,**
**dass** das Dichtungsmodul (4) tauschbar ist.

3. Baugruppe nach Anspruch 1 oder 2,
**dadurch gekennzeichnet,**
**dass** abhängig vom Einsatzfall Dichtungsmodule (4) mit unterschiedlichen Dichtungen (5, 6) einsetzbar sind.

4. Baugruppe nach einem der vorhergehenden Ansprüche,
**dadurch gekennzeichnet,**
**dass** die Dichtungen (5, 6) unverlierbar in das Dichtungsmodul (4) eingebracht sind.

5. Baugruppe nach einem der vorhergehenden Ansprüche,
**dadurch gekennzeichnet,**
**dass** die Teilkomponenten (2, 3) Gehäuseteile (10, 11) aufweisen, wobei die Gehäuseteile (10, 11) zu einem Gehäuse (12) der Baugruppe (1) zusammensetzbar sind und das Dichtungsmodul (4) zur Abdichtung des Gehäuses (12) vorgesehen ist.

6. Baugruppe nach einem der vorhergehenden Ansprüche,
**dadurch gekennzeichnet,**
**dass** das Dichtungsmodul (4) elektronische Bauteile aufweist.

7. Dichtungsmodul nach einem der vorhergehenden Ansprüche,
**dadurch gekennzeichnet,**
**dass** die Dichtungen (5, 6) unverlierbar in das Dichtungsmodul (4) eingebracht sind.

8. Dichtungsmodul nach einem der vorhergehenden Ansprüche,
**dadurch gekennzeichnet,**
**dass** das Dichtungsmodul (4) zur Abdichtung eines Gehäuses (12) der Baugruppe (1) vorgesehen ist.

9. Dichtungsmodul nach einem der vorhergehenden Ansprüche,
**dadurch gekennzeichnet,**
**dass** es elektronische Bauteile aufweist.

## Claims

1. Assembly (1) embodied as a peripheral module of a programmable logic controller of an industrial automation system with at least two component parts (2, 3), which are able to be combined to form the assembly (1), having a sealing module (4) to accept seals (5, 6) which is arranged between the two component parts (2, 3), wherein the sealing module (4) has corresponding receptacles on its upper and on its lower side to accept the seals (5, 6), wherein one component part (2) is embodied as a plug module for connection of external lines and the sealing module (4) has electrical contact means (7) for coupling with electrical contact means (8, 9) of the component parts (2, 3).

2. Assembly according to claim 1,
**characterised in that**
the sealing module (4) is exchangeable.

3. Assembly according to claim 1 or 2,
**characterised in that,**
depending on the application, sealing modules (4) with different seals (5, 6) are able to be used.

4. Assembly according to one of the preceding claims,
**characterised in that**
the seals (5, 6) are fitted captive in the sealing module (4).

5. Assembly according to one of the preceding claims,
**characterised in that**
the component parts (2, 3) comprise housing parts (10, 11), wherein the housing parts (10, 11) are able to be assembled to form a housing (12) of the assembly (1) and the sealing module (4) is provided for sealing the housing (12).

6. Assembly according to one of the preceding claims,
**characterised in that**
the sealing module (4) has electronic components.

7. Sealing module according to one of the preceding claims,
**characterised in that**
the seals (5, 6) are fitted captive in the sealing module (4).

8. Sealing module according to one of the preceding claims,
**characterised in that**
the sealing module (4) is provided for sealing a housing (12) of the assembly (1).

9. Sealing module according to one of the preceding claims,
**characterised in that**
it has electronic components.

## Revendications

1. Ensemble ( 1 ) constitué en module périphérique d'un automate programmable d'un système d'automatisation industriel, comprenant au moins deux sous-composants ( 2, 3 ) qui peuvent être assemblés en l'ensemble ( 1 ), comportant un module ( 4 ) d'étanchéité pour la réception de dispositifs d'étanchéité ( 5,6 ) qui sont disposés entre les deux sous-composants ( 2, 3 ), le module ( 4 ) d'étanchéité ayant des logements correspondants sur un côté supérieur et sur un côté inférieur pour la réception des dispositifs d'étanchéité ( 5, 6 ), un sous-composants ( 2 ) étant constitué en module de connecteur pour le raccordement de lignes extérieures, et en ce que le module ( 4 ) d'étanchéité comporte des moyens ( 7 ) de contact électriques pour le couplage à des moyens ( 8, 9 ) de contact électriques des sous-composants ( 2, 3 ).

2. Ensemble suivant la revendication 1, **caractérisé en ce que** le module ( 4 ) d'étanchéité est remplaçable.

3. Ensemble suivant la revendication 1 ou 2, **caractérisé en ce qu'**en fonction de l'utilisation des modules ( 4 ) d'étanchéité ayant des dispositifs d'étanchéité ( 5, 6 ) différents peuvent être utilisés.

4. Ensemble suivant l'une des revendications précédentes, **caractérisé en ce que** les dispositifs d'étanchéité ( 5, 6 ) sont mis dans le module ( 4 ) d'étanchéité de manière à ne pas pouvoir être perdus.

5. Ensemble suivant l'une des revendications précédentes, **caractérisé en ce que** les sous-composants ( 2, 3 ) ont des parties ( 10, 11 ) de boîtier, les parties ( 10, 11) de boîtier pouvant être assemblées en un boîtier ( 12 ) de l'ensemble ( 1 ) et le module ( 4 ) d'étanchéité étant prévu pour rendre étanche le boîtier.

6. Ensemble suivant l'une des revendications précédentes, **caractérisé en ce que** le module ( 4 ) d'étanchéité comporte des composants électroniques.

7. Module d'étanchéité suivant l'une des revendications précédentes, **caractérisé en ce que** les dispositifs d'étanchéité ( 5, 6 ) sont mis dans le module ( 4 ) d'étanchéité de manière à ne pas pouvoir être perdus.

8. Module d'étanchéité suivant l'une des revendications précédentes, **caractérisé en ce que** le module ( 4 ) d'étanchéité est prévu pour rendre étanche un boîtier ( 12 ) de l'ensemble ( 1 ).

9. Module d'étanchéité suivant l'une des revendications précédentes, **caractérisé en ce qu'**il comporte des composants électroniques.
